Europäisches Patentamt

European Patent Office

Office européen des brevets

(11) Numéro de publication: **0 036 804**
**A1**

(12) # DEMANDE DE BREVET EUROPEEN

(21) Numéro de dépôt: **81400394.3**

(22) Date de dépôt: **13.03.81**

(51) Int. Cl.³: **G 01 R 1/067**

(30) Priorité: **26.03.80 FR 8006691**

(43) Date de publication de la demande: **30.09.81**
**Bulletin 81/39**

(84) Etats contractants désignés: **AT BE CH DE GB IT LI LU NL SE**

(71) Demandeur: **SOCIETE D'ETUDES TECHNIQUES ET D'ENTREPRISES GENERALES SODETEG-T.A.I., 283, rue de la Minière Z.I. Nord, F-78530 BUC (FR)**

(72) Inventeur: **Jamet, Michel, THOMSON-CSF SCPI 173, bld Haussmann, F-75360 PARIS CEDEX 08 (FR)**
Inventeur: **Urien Jean-Claude, THOMSON-CSF SCPI 173, bld Haussmann, F-75360 PARIS CEDEX 08 (FR)**
Inventeur: **Bureau, Gérard, THOMSON-CSF SCPI 173, bld Haussmann, F-75360 PARIS CEDEX 08 (FR)**

(74) Mandataire: **Eisenbeth, Jacques Pierre et al, "THOMSON-CSF" - SCPI 173, bld Haussmann, F-75360 Paris Cedex 08 (FR)**

(54) **Palpeur pour dispositif de test de circuits imprimés, et dispositif de test incorporant un tel palpeur.**

(57) Palpeur pour dispositif de test de circuits imprimés nus et équipés de composants, dont la tête est usinée dans un élément de cylindre conducteur disposé à l'extrémité d'une tige coulissant dans un corps de piston et comporte une partie pyramidale centrale entourée à sa base par une couronne présentant des arêtes vives curvilignes. Les contacts avec les circuits imprimés nus ou équipés de composants se font par la partie pyramidale et/ou la couronne suivant les positions réciproques de la tête du palpeur et des trous métallisés, ou queues de connexion des composants ou points de soudure des circuits soumis au test.

Application aux dispositifs de test des circuits imprimés.

1

# PALPEUR POUR DISPOSITIF DE TEST DE CIRCUITS IMPRIMES ET DISPOSITIF DE TEST INCORPORANT UN TEL PALPEUR

La présente invention concerne un palpeur pour dispositif de test de circuits imprimés, qu'ils soient nus ou équipés de composants. Se réalisant sur une grande échelle et à la suite d'opérations semi-automatiques ou tout automatiques les circuits imprimés doivent être vérifiés, avant leur livraison ou leur utilisation, pour que l'on puisse s'assurer de leurs bonnes conditions de fonctionnement et détecter a contrario les endroits où ils présentent des défauts. En général, les vérifications ou tests sont exécutés automatiquement à l'aide d'appareils testeurs ou dispositifs de test vérifiant un nombre de points sur ces circuits, pouvant aller jusqu'à 4000, les tests étant de plus faits dans un temps relativement très court de l'ordre de 5 secondes ou moins quelquefois.

Un dispositif de test de circuits imprimés comprend en général trois parties, un système de base, des têtes de mesure et un groupe d'aspiration. Les rôles respectifs de ces différentes parties sont les suivants. Le système de base assure l'interface entre les têtes de mesure et un testeur de câblage ; les têtes de mesure assurent l'interface entre les circuits imprimés à tester et le système de mesure et le groupe d'aspiration a pour but d'assurer dans le dispositif, une certaine dépression pour appliquer le circuit imprimé soumis au test contre la tête de mesure et assurer un meilleur contact entre le circuit et les palpeurs que comporte la tête de mesure, palpeurs qui sont destinés à établir une liaison électrique entre un point du circuit imprimé sur lequel la tête du palpeur est venue s'appuyer et le testeur de câblage.

Le test des circuits imprimés doit pouvoir s'effectuer, que le circuit soit nu ou qu'il soit équipé de composants ; cependant actuellement un même palpeur ne permet pas d'effectuer les deux tests précédents dans de bonnes conditions. Si les palpeurs utilisés pour le test des circuits nus dont la tête consiste en une pointe, sont capables d'établir le contact avec les trous métallisés du circuit, il n'en sera plus de même pour les circuits équipés où les queues de connexion des composants dotées d'une certaine souplesse ne pourront être agrippées par la tête du palpeur ; il y aura soit absence de contact, soit mauvais contact et le test ne sera pas probant. Pour tester un circuit équipé, il faudra donc changer les palpeurs. Dans certaines réalisations, les têtes de palpeurs utilisées pour le test de circuits imprimés équipés de composants sont soit striées, soit couronnées. Dans ce cas, si l'agrippage des queues de connexion se fait dans de meilleures conditions ainsi que le contact avec des points de soudure, il n'en est plus de même si l'on veut passer au test d'un circuit imprimé nu, la tête du palpeur ne pouvant effectuer un contact avec un trou métallisé. De plus, la tête du palpeur dans ce cas ayant une certaine surface, il y a risque d'établissement d'un contact à la fois avec la pastille qui entoure l'orifice d'un trou métallisé et des pistes qui se trouvent à proximité. Il y a risque de court-circuits.

L'invention vise à éviter de tels désagréments tout en définissant un palpeur capable d'être utilisé pour le test des circuits imprimés nus comme pour celui des circuits imprimés équipés de composants.

Selon l'invention, un palpeur pour dispositif de test de circuits imprimés opérant par établissement de contacts électriques entre la tête du palpeur et le circuit imprimé soumis au test, la tête étant disposée à l'extrémité d'une tige coulissant dans un corps de piston, est caractérisé en ce que la tête du palpeur est usinée dans un élément de cylindre conducteur monté à l'extrémité de la tige coulissante de façon qu'elle présente une partie pyramidale centrée sur l'axe de symétrie de l'élément de cylindre, avec des gorges usinées au pied des faces de la pyramide, ménageant une couronne comportant des arêtes vives curvilignes dont la hauteur est sensiblement inférieure à la hauteur du sommet de la pyramide, définissant une configuration autorisant avec un même palpeur le test d'un circuit imprimé nu et d'un circuit imprimé équipé de composants.

3

D'autres avantages et caractéristiques de l'invention ressortiront de la description d'un exemple de réalisation, donné à l'aide des figures qui représentent :

- la figure 1, une représentation générale d'un palpeur suivant l'invention ;

- la figure 2, une vue de dessus de la tête du palpeur suivant l'invention ;

- la figure 3, une vue en plan de la tête du palpeur ;

- la figure 4, une vue en coupe de la tête du palpeur et son utilisation au test d'un circuit imprimé nu ;

- les figures 5, 6 et 7, des vues en coupe du palpeur et son utilisation au test d'un circuit imprimé équipé de composants.

Comme cela a été indiqué dans la partie introductrice de la présente demande, l'invention a pour objet de définir un palpeur pour dispositif de test de circuits imprimés, qui soit utilisable que le circuit imprimé soit nu, ou qu'il soit équipé de composants.

On a indiqué que les palpeurs de l'art antérieur ne pouvaient être utilisées pour effectuer les deux tests. De fait un palpeur dont la tête est effilée et arrondie est plus particulièrement apte à tester les trous métallisés du circuit dans lesquels il peut pénétrer, mais s'adapte mal au test des circuits équipés, les queues de connexion des composants ou les points de soudure ne pouvant établir un contact précis avec sa tête arrondie. Un palpeur dont la tête est striée ou couronnée est particulièrement apte à tester les circuits imprimés équipés, les stries ou les trous de la couronne permettant un agrippage plus facile des queues de connexion ou des points de soudure, mais ne peut tester les trous métallisés d'un circuit nu. De plus, les stries ou les crans étant pratiquement tous à un même niveau il y a un risque de courts-circuits, la tête du palpeur pouvant entrer en contact à la fois avec la pastille bordant l'orifice du trou métallisé et des pistes situées à proximité.

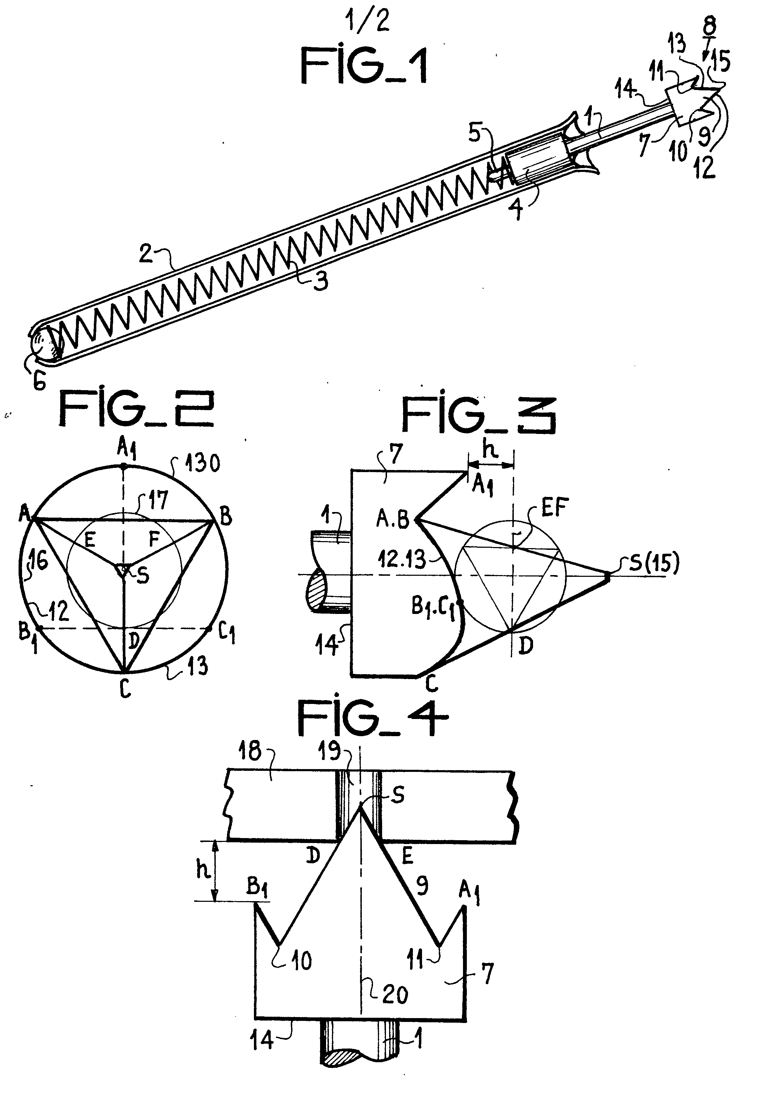

La figure 1 représente un palpeur suivant l'invention. Celui-ci comporte une tige coulissante ou piston 1 pouvant se déplacer dans un corps cylindrique 2 dans lequel se trouve un ressort 3 prenant appui sur la face interne 4 du piston munie d'un têton 5 et sur une bille 6 située à l'extrémité du corps cylindrique à l'opposé du piston. Le piston 1 se termine par une tête usinée dans un élément de cylindre circulaire 7 de façon à présenter un profil 8 en coupe cranté. De façon plus précise, l'usinage est réalisé de façon que la tête présente une partie 9 constituant une pyramide de base triangulaire, les creux 10 et 11 étant des gorges creusées dans l'élément de cylindre, au pied des faces triangulaires de la pyramide, ménageant autour de la base triangulaire une couronne présentant trois arêtes vives telles que 12-13. On notera que la hauteur des arêtes 12 et 13 comptée à partir de la base 14 de l'élément cylindrique dans lequel est usinée la tête du palpeur est nettement inférieure à la hauteur à laquelle se situe le sommet 15 de la pyramide, déterminant une hauteur de garde.

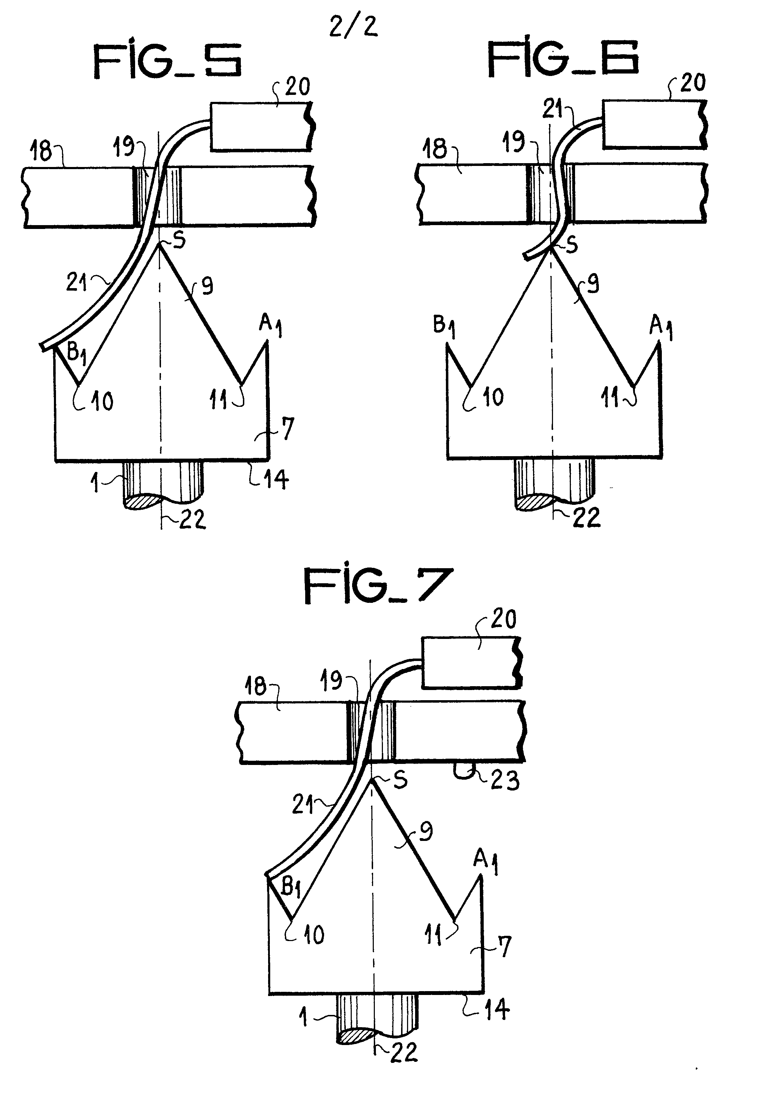

La figure 2 représente une vue de dessus de la tête du palpeur, tandis que la figure 3 représente une vue en plan de cette tête. Sur la figure 2 on reconnaît la pyramide SABC de base triangulaire, inscrite dans le cercle 16, base du cylindre dans lequel la tête du palpeur est usinée. On reconnaît sur les figures 2 et 3, les arêtes SA, SB, SC de la pyramide de sommet S, SA et SB étant confondues sur le dessin de la figure 3, le point commun AB sur la figure 3 imageant le fond de la gorge creusée au pied de la base de la face SAB de la pyramide. De la même façon on reconnaît l'arête SC de la pyramide. Entre les points A, B, C sommets du triangle de base de la pyramide se placent les arêtes de la couronne qui est usinée dans la tête du palpeur, ces arêtes AB, BC et CA étant sur la surface du cylindre de base dans lequel est fabriquée la tête du palpeur. Ces arêtes curvilignes présentent une pointe située sensiblement au milieu de l'arête correspondante, pointes qui sont référencées A1, B1 et C1 sur les figures 2 et 3, A1 et B1 étant référencées 12 et 13 sur la figure 1.

On notera que la fabrication d'une telle tête se fait par tout moyen approprié, par exemple par fraisage.

On a dessiné sur les figures 2 et 3 un cercle 17 qui représente un trou métallisé d'une plaque de circuit imprimé dans lequel peut s'introduire la partie pyramidale de la tête du palpeur considéré, les arêtes de cette partie pyramidale venant au contact du trou aux points DEF.

La figure 4 représente en coupe la tête du palpeur suivant l'invention utilisé pour effectuer le test d'un circuit imprimé nu. En 18 on a dessiné le circuit imprimé nu dans lequel se trouve par exemple un trou métallisé 19. Au moment du test, lorsque le circuit imprimé 18 est appliqué par la dépression qui est créée dans le dispositif de test, sur la tête de mesure du dispositif de test non représentée sur la figure, la tête du palpeur pénêtre dans le trou par sa partie pyramidale 9 sans difficulté et le contact s'établit aux points D et E. On notera que la position de ces points D et E sur les arêtes de la pointe pyramidale 9 de la tête dépend de l'angle au sommet de la pyramide, donc de l'inclinaison des arêtes par rapport à l'axe de symétrie 29 de la pyramide. Cette inclinaison est choisie telle que le contact de la pyramide avec les trous ait lieu alors que les arêtes de la couronne A1 et B1 sont dans une position empêchant tout contact entre elles et le circuit imprimé. La distance h constitue la hauteur de garde qui a été définie précédemment.

Les figures 5, 6 et 7 représentent en coupe la tête d'un palpeur suivant l'invention utilisé pour effectuer le test d'un circuit imprimé équipé de composants dont un, repéré 20 est représenté avec sa queue de connexion 21 passant à travers un trou métallisé 19.

Au moment du test, effectué avec un palpeur dont la tête est conforme à l'invention, et qui est utilisable, comme on l'a vu pour effectuer le test d'un circuit imprimé nu, la queue de connexion peut avoir différentes positions par rapport à la tête du palpeur.

Sur la figure 5, la queue 21, entre en contact avec l'arête B1 de la couronne et restera au contact par agrippage et blocage dans la gorge 10.

Sur la figure 6, la queue de connexion 21 entrera en contact avec le sommet S de la pyramide et pourra être bloqué en contact dans la gorge 10 également.

6

Sur la figure 7, la queue de connexion 21 sera tout de suite bloquée en contact dans la gorge 10 de la tête du palpeur.

Différentes autres positions relatives de la tête du palpeur et de queues de connexion de composants peuvent être imaginées, celles représentées constituant des positions particulières auxquelles toutes les autres peuvent être ramenées.

Les cas de figures 4 à 7 montrent seulement que la tête de palpeur suivant l'invention est utilisable à la fois pour les tests de circuits imprimés nus et de circuits imprimés équipés de composants.

On notera que la tête de palpeur suivant l'invention est également capable de tester les points de soudure, tels que 23 qui font saillie à partir de la plaque de circuit imprimé et qui sont agrippés, tout comme les queues de connexion par la couronne usinée dans la tête du palpeur.

On notera également que la tête de palpeur comporte une partie centrale pyramidale à base triangulaire et une couronne à trois pointes. Cette configuration est une configuration optimale, alliant la possibilité d'établir dans les conditions optimales les contacts lors des tests de circuits nus et équipés à la facilité de fabrication des têtes.

Dans un exemple de réalisation, le triangle de base de la pyramide est équilatéral et l'angle d'une gorge est de 60°.

On a ainsi décrit un palpeur, plus précisément une tête de palpeur pour dispositif de test de circuits imprimés, qu'ils soient nus ou équipés de composants.

7

## REVENDICATIONS

1. Palpeur pour dispositif de test de circuits imprimés par établissement de contacts électriques entre la tête du palpeur et le circuit imprimé soumis au test, la tête étant disposée à l'extrémité d'une tige coulissant dans un corps de piston, caractérisé en ce que la tête du palpeur est usinée dans un élément de cylindre conducteur (7) monté à l'extrémité de la tige coulissante (1) de façon telle qu'elle présente une partie pyramidale (9) centrée sur l'axe de symétrie de l'élément cylindrique avec des gorges (10-11) usinées au pied des faces de la pyramide, ménageant une couronne comportant des arêtes vives curvilignes (12-13), dont la hauteur est sensiblement inférieure à la hauteur du sommet de la pyramide, définissant une configuration autorisant avec un même palpeur le test d'un circuit imprimé nu et d'un circuit imprimé équipé de composants.

2. Palpeur suivant la revendication 1, caractérisé en ce que la partie pyramidale (9) de la tête est à base triangulaire et que la couronne ménagée à la base de l'élément de cylindre (7), entourant la partie pyramidale présente trois arêtes vives curvilignes (12-13), les hauteurs relatives des pointes (A1-B1-C1) de ces arêtes vives et du sommet (S) de la pyramide (9) ménageant une hauteur (h) dite de garde.

3. Palpeur suivant l'une des revendications 1 ou 2, caractérisé en ce que la partie pyramidale (9) de la tête d'un palpeur établit par ses arêtes (SA, SB, SC) un contact avec un trou métallisé (10) d'un circuit imprimé, en des points (DEF).

4. Palpeur suivant l'une des revendications 1 ou 2, caractérisé en ce que le contact entre la tête du palpeur et un trou métallisé (19) d'un circuit imprimé est établi par la partie pyramidale (9) de la tête qui a pénétré dans le trou (19), l'inclinaison des arêtes de la pyramide étant telle qu'elle détermine une hauteur (h) dite de garde entre le circuit imprimé soumis au test et les pointes ($A_1$, $B_1$, $C_1$) de la couronne.

5. Palpeur suivant l'une des revendications 1 ou 2, caractérisé en ce

8

que le contact entre la tête du palpeur et la queue de connexion (21) d'un composant placé sur le circuit imprimé soumis au test ou un point de soudure, est établi par la couronne par ses arêtes vives curvilignes et/ou ses pointes ($A_1$, $B_1$, $C_1$) ainsi que la partie pyramidale (9) suivant les positions desdites queues de connexion ou points de soudure par rapport à la tête.

6. Dispositif de test d'un circuit imprimé nu ou équipé de composants, caractérisé en ce qu'il comporte, pour l'établissement des contacts lors des tests, des palpeurs conformément à l'une des revendications 1 à 4.

# FIG_1

# FIG_2

# FIG_3

# FIG_4

## FIG_5

## FIG_6

## FIG_7

## DOCUMENTS CONSIDERES COMME PERTINENTS

| Catégorie | Citation du document avec indication, en cas de besoin, des parties pertinentes | Revendication concernée |
|---|---|---|
| A | <u>CH - A - 589 947</u> (INGUN A.G.)<br>* Colonne 1, lignes 18-42; colonne 2, lignes 22-35; figures 6-8 * | 1 |
| A | <u>DE - A - 1 765 461</u> (A. BOSSERT)<br>* Page 10, dernier alinéa; page 11, figure 1 * | 1 |
| A | <u>FR - A - 2 375 601</u> (TERADYNE, INC)<br>* Page 5, lignes 1-40; figures 1-3 * | 1 |

**CLASSEMENT DE LA DEMANDE (Int. Cl.³)**

G 01 R 1/067

**DOMAINES TECHNIQUES RECHERCHES (Int. Cl.³)**

G 01 R 1/067

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 04-06-1981 | KUSCHBERT |